# EUROPÄISCHE PATENTSCHRIFT

(11) **EP 3 292 049 B1**
(45) Veröffentlichungstag und Bekanntmachung des Hinweises auf die Patenterteilung: **05.09.2018**
(21) Anmeldenummer: 16706154.8
(22) Anmeldetag: 15.02.2016
(51) Int. Cl.: B65C 9/28

(54) **VORRICHTUNG UND VERFAHREN ZUM ETIKETTIEREN VON EINZELNEN PRODUKTEN**
APPARATUS AND METHOD FOR LABELLING INDIVIDUAL PRODUCTS
DISPOSITIF ET PROCÉDÉ D'ÉTIQUETAGE DE PRODUITS INDIVIDUELS

(30) Priorität: 04.05.2015 DE 102015106861
(43) Veröffentlichungstag der Anmeldung: 14.03.2018
(73) Patentinhaber: Espera-Werke GmbH, 47058 Duisburg (DE)
(72) Erfinder: VICKTORIUS, Winfried, 47249 Duisburg (DE); JUNG, Ulrich, 44287 Dortmund (DE)
(74) Vertreter: Gottschald Patentanwälte Partnerschaft mbB
(86) Internationale Anmeldenummer: PCT/EP2016/053144
(87) Internationale Veröffentlichungsnummer: WO 2016/177486

(56) Entgegenhaltungen:
- DE-A1- 3 407 837
- JP-A- 2004 237 988
- JP-A- 2008 074 422
- US-A- 3 888 725

## Beschreibung

Die vorliegende Erfindung betrifft eine Vorrichtung und ein Verfahren, gemäß dem Oberbegriff der Ansprüche 1 und 14, zum Etikettieren von einzelnen Produkten, insbesondere Packungen oder Waren. Eine Vorrichtung und ein Verfahren der eingangs genannten Art sind beispielsweise aus JP 2004 237988 A bekannt. Die EP 0 883 549 B1, der DE 10 2010 040 009 A1 und DE 10 2011 012 919 A1 zeigen weitere Vorrichtungen und Verfahren zum Etikettieren von einzelnen Produkten. Hier werden Packungen über eine nicht näher spezifizierte Vorschubeinrichtung einer Etikettenaufbringeinrichtung zugeführt, die einen Blaskopf zum Aufbringen eines Etiketts auf die Oberseite der jeweiligen Packung durch Abblasen aufweist. Dazu wird die Packung in Schwerkraftrichtung vertikal unterhalb des Blaskopfes angeordnet, das heißt vertikal unterhalb eines Abschnitts des Blaskopfes mit einer Vielzahl von Gehäuseöffnungen, die sowohl zum Ansaugen als auch Abblasen des jeweiligen Etiketts dienen. Ein am unteren Gehäuseteil des Blaskopfes in einer Abblasposition anhaftendes Etikett wird, sobald sich die Packung unterhalb des Etiketts befindet, durch einen aus den Gehäuseöffnungen austretenden und zur Vorschubeinrichtung bzw. Packung gerichteten Druckluftstoß abgeblasen und dadurch auf die Packung übertragen. Im Sinne der Erfindung ist als Abblasposition eine Position definiert, in der das auf das Produkt zu übertragende Etikett den Blaskopf berührt und im Wirkungsbereich derjenigen der Gehäuseöffnungen angeordnet ist, durch die der Druckluftstoß austritt/ausgegeben wird. Diese Position kann für unterschiedlich große Etiketten unterschiedlich sein. Eine bekannte Vorrichtung weist eine Etikettenspendeeinrichtung auf, in die eine Druckeinrichtung zum Bedrucken der Etiketten integriert ist. Die bedruckten Etiketten werden hier am Auslass einer Etikettenspendeeinrichtung bereitgestellt. Das jeweils bereitgestellte Etikett überlappt mit der Blaskopfunterseite und wird dort angesaugt, wodurch das Etikett von der Etikettenspendeeinrichtung zur Etikettenaufbringeinrichtung übertragen wird.

Bei dem genannten Stand der Technik wird das Etikett in der Abblasposition im Bereich der Gehäuseöffnungen gehalten durch Erzeugen eines Saugdrucks bzw.

Saugluftstroms durch die Gehäuseöffnungen. Ein und dieselben Öffnungen dienen gleichzeitig als Ansaugöffnungen und Blasöffnungen. Zum Erzeugen der Saugkraft, die das Etikett im Bereich der Öffnungen an der Unterseite des Blaskopfgehäuses ansaugt (anpresst), ist im Innern des Blaskopfes eine Unterdruckerzeugungseinheit angeordnet, die für den Ansaugvorgang mit den Öffnungen in einer Fluidverbindung steht. Zum Abblasen des Etiketts in Richtung der Packung ist eine Überdruckerzeugungseinheit im Blaskopf angeordnet, die kurzzeitig über eine Ventilanordnung mit denselben Öffnungen, die zuvor den Saugdruck aufgebaut haben, in Fluidverbindung bringbar ist, um den Druckluftstoß zu erzeugen, der das Etikett auf die Packung überträgt.

Die Ventilanordnung im Blaskopf ist relativ komplex aufgebaut. So ist zum einen ein Dreiwege-Magnetventil und zum anderen eine in einer Membrankammer hin- und herbewegbare und formveränderbare Topfmembran vorgesehen, um in einer Druckkammer einen Überdruck bereitzustellen und diesen für den Druckluftstoß schlagartig abzulassen/freizugeben. Die Druckkammer wird zunächst dadurch befüllt, dass von dem Dreiwege-Magnetventil der Druckluftanschluss freigegeben wird, so dass Druckluft (Luft mit einem Druck, der höher als der atmosphärische Druck oder Umgebungsdruck ist) vom Druckluftanschluss durch das Dreiwege-Magnetventil, dann durch die Membrankammer vorbei an der Topfmembran in die Druckkammer strömt. Beim Einströmen der Druckluft in die Druckkammer wird die Topfmembran dicht gegen den Einlass einer Einblasbohrung gedrückt, die mit einer separaten Verteilerkammer in ständiger Fluidverbindung steht, die wiederum mit den Gehäuseöffnungen in ständiger Fluidverbindung steht. Sobald die Druckkammer ausreichend gefüllt ist, wird das Dreiwege-Magnetventil in eine Stellung umgeschaltet, in der der Druckluftanschluss geschlossen wird und gleichzeitig ein mit der Membrankammer in Fluidverbindung stehender Entlüftungskanal freigegeben wird. Die Seite der Membrankammer, von der zuvor die Druckluft eingeleitet und an der Topfmembran vorbei in die Druckkammer geleitet wurde, wird dadurch schlagartig entlüftet, was dazu führt, dass der Überdruck in der Druckkammer die Topfmembran verformt, dadurch an die Außenseite der Membrankammer presst, was wiederum dazu führt, dass die Topfmembran in der Membrankammer von ihrer bisherigen Position wegbewegt wird. Dadurch wird schlagartig der Einlass der Einblasbohrung freigegeben, wodurch die Druckluft aus der Druckkammer über die Einblasbohrung in die Verteilerkammer und von dort durch die Gehäuseöffnungen freigegeben wird. Der so erzeugte Druckluftstoß von der Druckkammer durch die Einblasbohrung, weiter durch die Verteilerkammer und schließlich durch die Gehäuseöffnungen transportiert das Etikett dann wie gesagt zum Produkt.

Für eine möglichst genaue Etikettenplatzierung ist es wichtig, den Druckluftstoß möglichst flächenmittig zu dem Etikett wirken zu lassen. Hierdurch erreicht man, dass der Druckluftstoß eine über die Etikettenfläche symmetrische Kraftverteilung erzielt. Dabei muss, wie auch bei dem zuvor beschriebenen Stand der Technik, berücksichtigt werden, dass für unterschiedliche Bedarfsfälle unterschiedlich große Etiketten vorgesehen sein können, die alle von der Etikettenspendeeinrichtung in die für das Etikett definierte Abblasposition bewegt werden. Dabei soll idealerweise für jede Etikettengröße der Druckluftstoß möglichst flächenmittig wirken. Bei dem zuvor beschriebenen Stand der Technik erfolgt eine Anpassung des Abschnitts mit Gehäuseöffnungen an unterschiedliche Etikettengrößen in Richtung von der Etikettenspendeeinrichtung zur Abblasposition durch ein manuell verstellbares Schieberelement, welches in der Richtung von der Etikettenspendeeinrichtung zur Abblasposition oder entgegen dieser Richtung horizontal verschoben werden kann, wodurch mehrere der Gehäuseöffnungen individuell blockiert oder freigegeben werden können. Auf diese Weise lässt sich eine Anpassung an unterschiedliche Etikettenlängen erzielen.

Für eine Anpassung an unterschiedliche Etikettenbreiten ist der gesamte Blaskopf und damit der Abschnitt mit den Gehäuseöffnungen quer zu der Richtung, die von der Etikettenspendeeinrichtung zur Abblasposition verläuft, relativ zur Etikettenspendeeinrichtung verstellbar. Letzteres erfolgt ebenfalls manuell.

Ein Nachteil bei dem zuvor beschrieben Stand der Technik ist, dass eine Bedienperson den Blaskopf bzw. die für den Druckluftstoß notwendigen Gehäuseöffnungen für jede unterschiedliche Etikettengröße individuell und mit hoher Genauigkeit einstellen muss. Dies ist besonders aufgrund der manuellen Einstellbarkeit recht aufwendig.

Insgesamt ist die aus dem Stand der Technik bekannte Vorrichtung zum Etikettieren von einzelnen Produkten also sehr komplex aufgebaut und relativ aufwendig in der Handhabung.

Davon ausgehend ist es eine Aufgabe der vorliegenden Erfindung, eine Vorrichtung und ein Verfahren zum Etikettieren von einzelnen Produkten, insbesondere Packungen oder Waren, zu schaffen, die einfacher aufgebaut ist.

Die zuvor hergeleitete und aufgezeigte Aufgabe wird gemäß einer ersten Lehre der vorliegenden Erfindung bei einer Vorrichtung zum Etikettieren von einzelnen Produkten, insbesondere Packungen oder Waren, gemäß dem Anspruch 1 gelöst. Mit einem Schieberelement ist ein Bauteil gemeint, das durch eine translatorische und/oder rotatorische Bewegung zwischen den genannten Positionen verlagerbar (verschiebbar) ist. Insbesondere handelt es sich um eine Platte konstanter Dicke. Einzelne oder alle der im Folgenden beschriebenen Schieberelemente können auf diese Weise ausgebildet und/oder verschiebbar sein.

Wenn von blockierbaren Gehäuseöffnungen die Rede ist, ist gemeint, dass durch diese Gehäuseöffnungen im durch das Schieberelement blockierten Zustand keine Fluidverbindung zwischen Druckkammer und Blaskopfumgebung besteht, das heißt bei einem in der Druckkammer höheren Druck als in der Umgebung keine Luft aus der Druckkammer durch diese Gehäuseöffnungen entweichen kann.

Wenn von einer ersten Position des Schieberelements die Rede ist, ist vorzugsweise eine Endposition gemeint. Wenn von einer zweiten Position des Schieberelements die Rede ist, ist vorzugsweise auch eine Endposition gemeint, aber nicht zwingend, sondern es kann sich bei der zweiten Position auch um eine Zwischenposition, insbesondere eine von mehreren Zwischenpositionen, zwischen der ersten und einer weiteren Endposition handeln.

Indem erfindungsgemäß als Teil des Blaskopfes bzw. als Teil der Etikettenaufbringeinrichtung, insbesondere im Innern der Druckkammer, zwei oder mehrere Schieberelemente vorgesehen sind, können die Gehäuseöffnungen, welche zum Ansaugen oder Abblasen dienen, unmittelbar in einem die Druckkammer begrenzenden Gehäuseteil vorgesehen sein. Dabei sind die wie zuvor beschriebenen Schieberelemente mit Löchern vorgesehen, um die Fluidverbindung zu den Gehäuseöffnungen für den Druckluftstoß freizugeben oder zum Aufbauen eines Überdrucks in der Druckkammer zu blockieren. Die Druckkammer kann auf diese Weise ständig mit der Überdruckerzeugungseinheit verbunden sein, das heißt es kann über den Druckluftanschluss ständig Druckluft in die Druckkammer eingeleitet werden, ohne dass ein separates Ventil die Druckluftzufuhr in die Druckkammer zwingend unterbrechen muss. Optional kann solch ein Ventil im Bedarfsfall dennoch vorgesehen sein. Außerdem wird auch keine den Aufbau einer Etikettenaufbringeinrichtung verkomplizierende Anordnung aus Membrankammer mit innenliegender Topfmembran, zusätzlicher Einblasbohrung und zusätzlicher Verteilerkammer benötigt, um für den Druckluftstoß schlagartig die Druckluft aus der Druckkammer freizusetzen. Die wie zuvor definierten Schieberelemente werden auch dazu eingesetzt, die Etikettenaufbringeinrichtung an unterschiedlich große Etiketten anzupassen. Wie im Weiteren noch beschrieben wird, kann mit einem oder zwei Schieberelementen ein individueller Bereich von Gehäuseöffnungen für den Druckluftstoß freigegeben werden, der dann jeweils für eine von mehreren verschiedenen Etikettenlängen und/oder -breiten optimiert ist. Auf diese Weise kann das Zentrum des Druckluftstoßes bzw. die Mitte des Bereichs mit den zur Erzeugung des jeweiligen Druckluftstoßes vorgesehenen (freigegebenen) Gehäuseöffnungen (durch die im Falle eines Druckluftstoßes nicht angesaugt, sondern abgeblasen wird) immer exakt zu unterschiedlich langen und/oder breiten Etiketten ausgerichtet werden. Mit dem Ausdruck "Freigeben eines individuellen Bereichs von Gehäuseöffnungen" ist gemeint, dass, wenn diese Gehäuseöffnungen nicht anderweitig (zum Beispiel durch ein anderes Schieberelement) blockiert sind, Luft aus der Druckkammer in die Umgebung entweichen kann.

Im Folgenden werden nun weitere Ausgestaltungen der erfindungsgemäßen Vorrichtung beschrieben.

So ist gemäß einer Ausgestaltung vorgesehen, dass die Etikettenaufbringeinrichtung mindestens drei Schieberelemente aufweist, die zwischen einer ersten Position, in der das jeweilige Schieberelement zumindest einige der Gehäuseöffnungen vollständig blockieren kann bzw. blockiert, und einer zweiten Position, in der das jeweilige Schieberelement diese Gehäuseöffnungen zumindest teilweise freigeben kann bzw. freigibt, bewegbar ist, wobei in jedem Schieberelement jeweils Löcher vorgesehen sind, die derart angeordnet sind, dass sie in der zweiten Position des jeweiligen Schieberelements mit den in der ersten Position durch das Schieberelement blockierbaren Gehäuseöffnungen zumindest teilweise in Überdeckung bringbar sind und in der ersten Position des jeweiligen Schieberelements zu diesen Gehäuseöffnungen versetzt sind, so dass keine Überdeckung gegeben ist. Bevorzugt weist die erfindungsgemäße Vorrichtung also zumindest ein als Verschlussschieber ausgebildetes Schieberelement auf, das heißt ein Schieberelement, welches die Gehäuseöffnungen vollständig blockiert, wenn ein Überdruck in der Druckkammer aufgebaut werden soll, und zumindest teilweise, bevorzugt vollständig, freigibt, um den Druckluftstoß zu erzeugen. Gleichzeitig weist die erfindungsgemäße Vorrichtung bevorzugt mindestens ein, vorzugsweise zwei, als Etikettengrößenanpassungsblende ausgebildete Schieberelemente auf, also Schieberelemente, mit denen ein bestimmter Bereich der Gehäuseöffnungen für den Druckluftstoß freigegeben und ein entsprechend anderer Bereich blockiert werden kann, um eine Ausrichtung des Druckluftstoßes möglichst flächenmittig zum Etikett auch bei unterschiedlichen Etikettenlängen und/oder -breiten zu erzielen. Bei jedem der erfindungsgemäß vorgesehenen Schieberelemente, sowohl beim Verschlussschieber, also auch bei der bzw. den Etikettengrößenanpassungsblenden, verbinden die Löcher immer die der Vorschubeinrichtung zugewandte mit der der Vorschubeinrichtung abgewandten Seite des jeweiligen Schieberelements, das heißt die Öffnungen weisen eine Mittelachse auf, die die der Vorschubeinrichtung zugewandte Seite und die der Vorschubeinrichtung abgewandte Seite des Schieberelements schneiden und insbesondere dazu senkrecht verlaufen.

Gemäß einer weiteren Ausgestaltung der erfindungsgemäßen Vorrichtung ist bzw. sind mindestens ein Schieberelement, vorzugsweise alle Schieberelemente, im Innern der Druckkammer angeordnet. Grundsätzlich ist es aber auch denkbar, zumindest den Verschlussschieber, der alle Öffnungen für den Druckluftstoß freigibt und anderenfalls blockiert, an der Außenseite (Unterseite) des Gehäuseteils mit den Gehäuseöffnungen vorzusehen.

Gemäß noch einer Ausgestaltung ist bzw. sind mindestens ein Schieberelement, vorzugsweise alle Schieberelemente, jeweils mit einem (die Bewegung bewirkenden) Antrieb verbunden. Der jeweilige Antrieb, der insbesondere mit einer Steuereinrichtung verbunden ist, bewegt das jeweilige Schieberelement zwischen der ersten und der zweiten Position.

Gemäß noch einer weiteren Ausgestaltung der erfindungsgemäßen Vorrichtung ist bzw. sind mindestens ein Schieberelement, vorzugsweise alle Schieberelemente, plattenförmig (das heißt als sogenannte Schieberplatte) ausgebildet. Eine solche Schieberplatte kann aus Metall bestehen und hat insbesondere eine Dicke in einem Bereich von 0,5 bis 5 mm, bevorzugt in einem Bereich von 1 bis 3 mm, besonders bevorzugt in einem Bereich von 1 bis 2 mm. Das jeweilige Schieberelement, insbesondere plattenförmige Schieberelement, kann auch beschichtet sein, beispielsweise um die Abdichtung zu optimieren und/oder eine besonders gute Gleitfähigkeit bei der Bewegung zu erzielen.

Gemäß wieder einer weiteren Ausgestaltung kann vorgesehen sein, dass mindestens ein Schieberelement, vorzugsweise alle Schieberelemente, winklig, insbesondere senkrecht, zur Abblasrichtung zwischen der jeweiligen ersten Position und zweiten Position bewegbar ist bzw. sind.

Im Folgenden werden verschiedene Ausgestaltungen einer erfindungsgemäßen Vorrichtung mit einem Verschlussschieber beschrieben.

So kann wie gesagt vorgesehen sein, dass mindestens ein Schieberelement einen Verschlussschieber bildet. Dieser ist so positionierbar und/oder dessen Löcher sind so angeordnet, dass er in der ersten Position alle Gehäuseöffnungen vollständig blockiert und in der zweiten Position mehrere, vorzugsweise alle, Gehäuseöffnungen zumindest teilweise, vorzugsweise vollständig, freigibt.

Gemäß einer Ausgestaltung liegt der Verschlussschieber dichtend an dem Gehäuseteil mit den Gehäuseöffnungen, insbesondere an der der Vorschubeinrichtung abgewandten Seite des Gehäuseteils, an, wodurch dieser in der ersten Position alle Gehäuseöffnungen direkt verschließt/abdeckt. Vorzugsweise ist der Verschlussschieber parallel zu dem Gehäuseteil, insbesondere senkrecht zu der Mittelachse der Gehäuseöffnungen, bewegbar.

Ferner kann in der Druckkammer mindestens eine stationäre Lochplatte mit Lochplattenöffnungen angeordnet sein, wobei die Anzahl an Lochplattenöffnungen insbesondere der Anzahl an Gehäuseöffnungen entspricht und die Lochplattenöffnungen (exakt) mit den Gehäuseöffnungen (in Abblasrichtung bzw. in Verlaufsrichtung der Mittelachse der Gehäuseöffnungen) fluchten, wobei sich die Lochplattenöffnungen zu den Gehäuseöffnungen hin insbesondere verengen (und dadurch Düsen bilden). Der engste Querschnitt der Lochplattenöffnungen entspricht dabei insbesondere dem Querschnitt der Gehäuseöffnungen. Der Verschlussschieber ist dann insbesondere zwischen der stationären Lochplatte und dem Gehäuseteil mit den Gehäuseöffnungen angeordnet. Dabei liegt der Verschlussschieber insbesondere auch dichtend an der stationären Lochplatte, insbesondere an der der Vorschubeinrichtung zugewandten Seite der stationären Lochplatte, an und ist vorzugsweise parallel zur stationären Lochplatte, insbesondere senkrecht zu der Mittelachse der Lochplattenöffnungen, bewegbar. Die Mittelachse der Lochplattenöffnungen verläuft dabei insbesondere koaxial zur Mittelachse der damit fluchtenden Gehäuseöffnungen. Indem der Verschlussschieber zwischen Lochplatte und Gehäuseteil angeordnet ist, wird die Dichtigkeit in der ersten Position des Verschlussschiebers optimiert, da zwischen der Druckkammer und der Außenseite des Blaskopfes in diesem Fall zwei Dichtflächen vorgesehen sind. Es können auch mehrere stationäre Lochplatten vorgesehen sein, wobei insbesondere eine oder jede der Lochplatten jeweils an der von der Vorschubeinrichtung abgewandten Seite des Verschlussschiebers angeordnet ist.

Gemäß einer weiteren Ausgestaltung der Vorrichtung ist vorgesehen, dass die Löcher des Verschlussschiebers verschiedene Lochquerschnitte, das heißt verschiedene Querschnittsformen und/oder Querschnittsflächen, haben, wobei die in einem (bezogen auf die Bewegungsrichtung des Verschlussschiebers) mittleren Abschnitt angeordneten Löcher insbesondere eine größere Länge (Abmessung in Bewegungsrichtung des Verschlussschiebers) und/oder eine größere Breite (Abmessung quer zur Bewegungsrichtung des Verschlussschiebers) und/oder eine größere Querschnittsfläche als die übrigen Löcher (das heißt die Löcher in den übrigen Abschnitten des Verschlussschiebers zu beiden Seiten des mittleren Abschnitts) haben.

Der mittlere Abschnitt ist definiert als ein Abschnitt, der sich insbesondere über die gesamte Breite (Abmessung quer zur Bewegungsrichtung des Verschlussschiebers) und/oder gesamte Länge (Abmessung in Bewegungsrichtung des Verschlussschiebers) des Verschlussschiebers erstreckt. Insbesondere ist vorgesehen, dass sich der mittlere Abschnitt dann über die gesamte Länge des Verschlussschiebers erstreckt, wenn die Bewegungsrichtung des Verschlussschiebers parallel zu der Richtung verläuft, in der das Etikett gespendet wird (Etikettenspenderichtung) und/oder von der Spendeposition zur Abblasposition transportiert wird (Etikettentransportrichtung). Entsprechend ist denkbar, dass sich der mittlere Abschnitt dann über die gesamte Breite des Verschlussschiebers erstreckt, wenn die Bewegungsrichtung des Verschlussschiebers orthogonal bzw. quer zu der Etikettenspenderichtung und/oder Etikettentransportrichtung verläuft.

Indem im mittleren Abschnitt Löcher mit größeren Abmessungen vorgesehen sind, wird erreicht, dass beim Bewegen des Verschlussschiebers von der ersten Position, in der alle Gehäuseöffnungen blockiert sind, in Richtung der zweiten Position diejenigen Gehäuseöffnungen, die bei Erreichen der zweiten Position mit den Löchern des größeren Querschnitts im Verschlussschieber fluchten, eher freigegeben werden als die übrigen Öffnungen. Auf diese Weise lässt sich ein Druckluftstoß erzeugen, der das Etikett in einer Achsrichtung beim Abblasvorgang mittig leicht vorfaltet, um dadurch die Flugeigenschaften zu verbessern. Der Druckluftstoß bzw. die davon auf das Etikett wirkende Blaskraft wirkt dadurch über einer der Symmetrielinien des Etiketts früher und/oder stärker als in den Zonen daneben. Zu diesem Zweck ist es besonders bevorzugt, wenn die Löcher in dem mittleren Abschnitt eine größere Breite und eine größere Länge als die Löcher in den übrigen Abschnitten seitlich davon haben und insbesondere als Langlöcher ausgebildet sind, wohingegen die Löcher in den übrigen Abschnitten insbesondere als kreisrunde Löcher ausgebildet sind. Insbesondere entspricht der Lochquerschnitt der übrigen Löcher (das heißt der Löcher in den zum mittleren Abschnitt benachbarten Abschnitten) dem Querschnitt, vorzugsweise der Querschnittsform und/oder der Querschnittsfläche, der Gehäuseöffnungen.

Im Folgenden sollen nun einige Ausgestaltungen einer erfindungsgemäßen Vorrichtung mit einer oder mehreren Etikettengrößenanpassungsblenden beschrieben werden.

So kann wie gesagt erfindungsgemäß auch vorgesehen sein, dass mindestens zwei Schieberelemente jeweils eine Etikettengrößenanpassungsblende bildet. Diese ist so positionierbar und/oder deren Löcher sind so angeordnet, dass sie - wenn die Gehäuseöffnungen in dem Gehäuseteil nicht anderweitig, zum Beispiel durch den Verschlussschieber, blockiert sind -
- in der ersten Position mehrere Gehäuseöffnungen (bzw. Fluidverbindungen durch den Gehäuseteil mit den Gehäuseöffnungen) zumindest teilweise, vorzugsweise vollständig, freigibt und die übrigen Gehäuseöffnungen bzw. Fluidverbindungen vollständig blockiert und
- in der zweiten Position alle Gehäuseöffnungen bzw. Fluidverbindungen zumindest teilweise, vorzugsweise vollständig, freigibt.

Diesbezüglich sei nochmals hervorgehoben, dass die zweite Position nicht zwingend eine Endposition des Verschlussschiebers ist, sondern auch eine Zwischenposition zwischen zwei Endpositionen sein kann. Wenn es sich also bei der zweiten Position nicht um eine Endposition handelt, ist daher denkbar, dass die Etikettengrößenanpassungsblende so positionierbar ist und/oder ihre Löcher so angeordnet sind, dass sie - wenn die Gehäuseöffnungen in dem Gehäuseteil nicht anderweitig, zum Beispiel durch den Verschlussschieber, blockiert sind -
- in der ersten Position mehrere Gehäuseöffnungen vollständig freigibt und die übrigen Gehäuseöffnungen vollständig blockiert,
- in der zweiten Position (Zwischenposition) alle Gehäuseöffnungen teilweise freigibt oder nur einige der Gehäuseöffnungen vollständig freigibt und die übrigen teilweise oder vollständig blockiert und
- in einer dritten Position alle Gehäuseöffnungen vollständig freigibt.

Insbesondere sind zwei Schieberelemente vorgesehen, die jeweils eine Etikettengrößenanpassungsblende bilden, die so positionierbar ist und/oder deren Löcher so angeordnet sind, dass sie - wenn die Gehäuseöffnungen in dem Gehäuseteil nicht anderweitig, zum Beispiel durch den Verschlussschieber, blockiert sind - wenn es sich bei der zweiten Position nicht um eine Endposition handelt -
- in der ersten Position mehrere Gehäuseöffnungen vollständig freigibt und die übrigen Gehäuseöffnungen vollständig blockiert,
- in der zweiten Position (Zwischenposition) alle Gehäuseöffnungen teilweise freigibt oder nur einige der Gehäuseöffnungen vollständig freigibt und die übrigen teilweise oder vollständig blockiert und
- in einer dritten Position alle Gehäuseöffnungen vollständig freigibt.

Gemäß einer Ausgestaltung ist vorgesehen, dass - wenn die Gehäuseöffnungen nicht anderweitig blockiert sind - eine der Etikettengrößenanpassungsblenden in der ersten Position andere Gehäuseöffnungen (bzw. andere Fluidverbindungen durch den Gehäuseteil mit den Gehäuseöffnungen) freigibt als eine andere Etikettengrößenanpassungsblende. Mit einer der beschriebenen Etikettengrößenanpassungsblenden kann dann beispielsweise eine Anpassung des Blaskopfes bzw. der Etikettenaufbringeinrichtung an unterschiedliche Etikettenlängen erfolgen. Mit der anderen der Etikettengrößenanpassungsblenden kann eine Anpassung an unterschiedliche Etikettenbreiten erfolgen. Dabei ist es durchaus auch denkbar, dass die eine Etikettengrößenanpassungsblende und die andere Etikettengrößenanpassungsblende gleichzeitig in ihrer ersten Position positionierbar sind, wodurch dann - wenn die Gehäuseöffnungen nicht anderweitig blockiert sind - insbesondere eine geringere Anzahl an Gehäuseöffnungen bzw. Fluidverbindungen freigegeben ist als in dem Fall, dass nur die eine Etikettengrößenanpassungsblende oder nur die andere Etikettengrößenanpassungsblende in ihrer erste Position positioniert ist. Grundsätzlich ist dabei auch denkbar, dass, wenn beide Etikettengrößenanpassungsblenden in der ersten Position sind, alle Gehäuseöffnungen blockiert sind und/oder, wenn beide Etikettengrößenanpassungsblenden in der zweiten Position sind, alle Gehäuseöffnungen freigegeben sind.

Gemäß einer weiteren Ausgestaltung liegt mindestens eine Etikettengrößenanpassungsblende dichtend an der stationären Lochplatte, insbesondere an der der Vorschubeinrichtung abgewandten Seite der stationären Lochplatte, an und ist vorzugsweise parallel zu der stationären Lochplatte, insbesondere senkrecht zu der Mittelachse der Lochplattenöffnungen, bewegbar. Auch kann vorgesehen sein, dass eine Etikettengrößenanpassungsblende dichtend an einer anderen Etikettengrößenanpassungsblende, insbesondere an der der Vorschubeinrichtung abgewandten Seite der anderen Etikettengrößenanpassungsblende, anliegt und vorzugsweise parallel zu der anderen Etikettengrößenanpassungsblende, insbesondere senkrecht zu der Mittelachse der Löcher der anderen Etikettengrößenanpassungsblende, bewegbar ist. In letzterem Fall kann ebenfalls eine stationäre Lochplatte vorgesehen sein, an der dann die obere Etikettengrößenanpassungsblende (d.h. die von der Vorschubeinrichtung entfernteste der beiden Blenden) dichtend anliegt. Insbesondere ist vorgesehen, dass jede der Etikettengrößenanpassungsblenden und/oder die von der Vorschubeinrichtung entfernteste der Etikettengrößenanpassungsblenden dichtend an der stationären Lochplatte anliegt, wobei die dichtend an der stationären Lochplatte anliegende Etikettengrößenanpassungsblende insbesondere an der der Vorschubeinrichtung zugekehrten Seite der stationären Lochplatte anliegt.

Die Etikettengrößenanpassungsblende(n) ist bzw. sind vorzugsweise parallel zu dem Verschlussschieber, der alle Gehäuseöffnungen freigibt oder blockiert, bewegbar. Insbesondere sind beide Etikettengrößenanpassungsblenden in dieselbe Richtung und insbesondere in dieselbe Richtung wie der Verschlussschieber bewegbar.

Schließlich ist gemäß noch einer weiteren Ausgestaltung der erfindungsgemäßen Vorrichtung vorgesehen, dass sie ferner einen Produktdatenspeicher zum Bereitstellen von produktspezifischen Informationen (zum Beispiel Angaben zur Art des Produkts und/oder zur Länge, Breite und/oder Höhe des Produkts etc.) und einen Etikettendatenspeicher zum Bereitstellen von etikettenspezifischen Informationen (zum Beispiel Angaben zur Etikettenart, insbesondere hinsichtlich der Anwendung in einem Thermo-Direktdruckverfahren oder Thermo-Transferdruckverfahren, und/oder Angaben zur Länge und/oder Breite des Etiketts und/oder zur Druckintensität etc.) aufweist, wobei in dem Etikettendatenspeicher insbesondere die jeweilige Position der Etikettengrößenanpassungsblende(n) während des Druckluftstoßes individuell für verschiedene Etikettengrößen abgelegt (gespeichert) ist. Die jeweiligen Zuordnungen der Positionen zu den verschiedenen Etikettengrößen sind dabei bewusst nicht in dem Produktdatenspeicher abgelegt. So ist der Produktdatenspeicher für diese Informationen weniger geeignet, da das gleiche Produkt auf einer anderen Etikettiervorrichtung mit zum Beispiel einem pneumatisch betätigten Zylinder zum Aufbringen des jeweiligen Etiketts auf das Produkt eine andere Information benötigt. Anwender, die mehrere unterschiedliche Etikettiervorrichtungen benutzen, können also erfindungsgemäß ohne weiteres die gleiche Produktdatenbank auf all ihren Etikettiervorrichtungen nutzen, ohne daran Anpassungen vornehmen zu müssen. Die erfindungsgemäße Etikettiervorrichtung hat dazu einen von dem Produktdatenspeicher unabhängigen Etikettendatenspeicher, mit dem automatisch bei Auswahl eines bestimmten Etiketts, insbesondere einer bestimmten Etikettenlänge und/oder -breite, die erforderlichen Einstellungen am Blaskopf erfolgen können.

Die erfindungsgemäße Vorrichtung kann eine entsprechende Steuerungseinrichtung aufweisen, die mit dem Etikettendatenspeicher verbunden ist und dadurch selbsttätig den Zusammenhang zwischen Etikettengröße und vorzunehmenden Einstellungen erkennt und ausführt. Der Anwender muss diese Daten also gar nicht erst anlegen und pflegen.

Die zuvor hergeleitete und aufgezeigte Aufgabe wird ferner gemäß einer zweiten Lehre der vorliegenden Erfindung bei einem Verfahren zum Etikettieren von einzelnen Produkten, insbesondere Packungen oder Waren, gemäß dem Anspruch 14 gelöst. Gemäß einer Ausgestaltung des erfindungsgemäßen Verfahrens wird der Druckluftstoß dadurch erzeugt, dass ein einen Verschlussschieber bildendes Schieberelement von einer ersten Position, in der der Verschlussschieber alle Gehäuseöffnungen vollständig blockiert, während der Überdruck (in der Druckkammer) aufgebaut wird, in eine zweite Position bewegt wird, in der alle Gehäuseöffnungen zumindest teilweise, vorzugsweise vollständig, freigegeben sind. Gemäß noch einer Ausgestaltung des Verfahrens ist vorgesehen, dass vor dem Bewegen des Verschlussschiebers von der ersten Position in die zweite Position mindestens ein eine Etikettengrößenanpassungsblende bildendes Schieberelement, insbesondere zwei jeweils eine Etikettengrößenanpassungsblende bildende Schieberelemente, jeweils in eine Position bewegt wird/werden, in der die jeweilige Etikettengrößenanpassungsblende - wenn die Gehäuseöffnungen in dem Gehäuseteil nicht anderweitig, zum Beispiel durch den Verschlussschieber, blockiert sind - mehrere Gehäuseöffnungen zumindest teilweise, vorzugsweise vollständig, freigibt und die übrigen Gehäuseöffnungen vollständig blockiert.

Es gibt nun eine Vielzahl von Möglichkeiten, die erfindungsgemäße Vorrichtung und das erfindungsgemäße Verfahren auszugestalten und weiterzubilden. Diesbezüglich sei einerseits verwiesen auf die abhängigen Patentansprüche, andererseits auf die Beschreibung von Ausführungsbeispielen in Verbindung mit der Zeichnung. In der Zeichnung zeigt:
- Fig. 1: eine schematische Seitenansicht einer erfindungsgemäßen Vorrichtung zum Etikettieren von einzelnen Produkten,
- Fig. 2: eine schematische Schnittansicht eines Teils eines Blaskopfes für die Vorrichtung in Fig. 1, der aber mit nur einem Schieberelement und somit nicht erfindungsgemäß ausgebildet ist,

- Fig. 3: eine schematische Schnittansicht eines Ausschnitts des Blaskopfes in Fig. 2,

- Fig. 4: eine schematische Ansicht eines Verschlussschiebers eines Blaskopfes für eine erfindungsgemäße Vorrichtung,
- Fig. 5: eine schematische Schnittansicht eines Teils eines Ausführungsbeispiels eines Blaskopfes für die Vorrichtung in Fig. 1, gemäß der vorliegenden Erfindung, und
- Fig. 6a)-6c): verschiedene Stellungen von Etikettengrößenanpassungsblenden eines Blaskopfes für die Vorrichtung in Fig. 1.

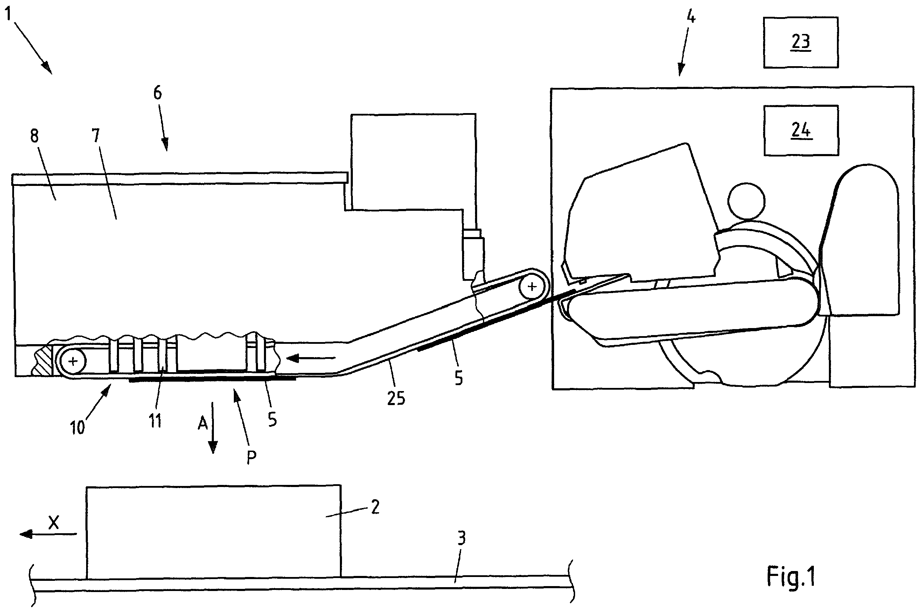

In Fig. 1 ist eine Vorrichtung 1 zum Etikettieren von einzelnen Produkten 2, insbesondere Packungen oder Waren, dargestellt. Die Vorrichtung 1 weist eine Vorschubeinrichtung 3 zum Transport eines jeweiligen Produkts 2 entlang eines Transportweges auf. Ferner ist eine Etikettenspendeeinrichtung 4 zum Bereitstellen von Etiketten 5 und eine Etikettenaufbringeinrichtung 6 mit einem Blaskopf 7 zum Aufbringen des jeweiligen Etiketts 5 auf die Oberfläche des Produkts 2 Bestandteil der Vorrichtung 1.

Im Betrieb der Vorrichtung 1 wird das jeweils zu etikettierende Produkt 2 auf der Vorschubeinrichtung 3, bei der es sich beispielsweise um einen Bandförderer handelt, in eine Produkttransportrichtung X transportiert. Während des Transports des Produkts 2 wird mittels der Etikettenspendeeinrichtung 4 ein Etikett 5 von einem Trägerstreifen im Innern der Etikettenspendeeinrichtung 4 gelöst und anschließend dem Blaskopf 7 zugeführt. Letzteres erfolgt bei dem in Fig. 1 dargestellten Ausführungsbeispiel mittels einer Fördereinrichtung 25, die jedes bereitgestellte Etikett 5 einzeln von der Etikettenspendeeinrichtung 4 in eine als Abblasposition P bezeichnete Stellung vertikal unterhalb des Blaskopfes 7 fördert. Von der Abblasposition P wird das jeweilige Etikett 5 dann, sobald sich das Produkt 2 vertikal unterhalb der Abblasposition P befindet, mittels eines Druckluftstoßes, der vom Blaskopf 7 erzeugt wird, in einer Abblasrichtung A auf das Produkt 2 abgeblasen.

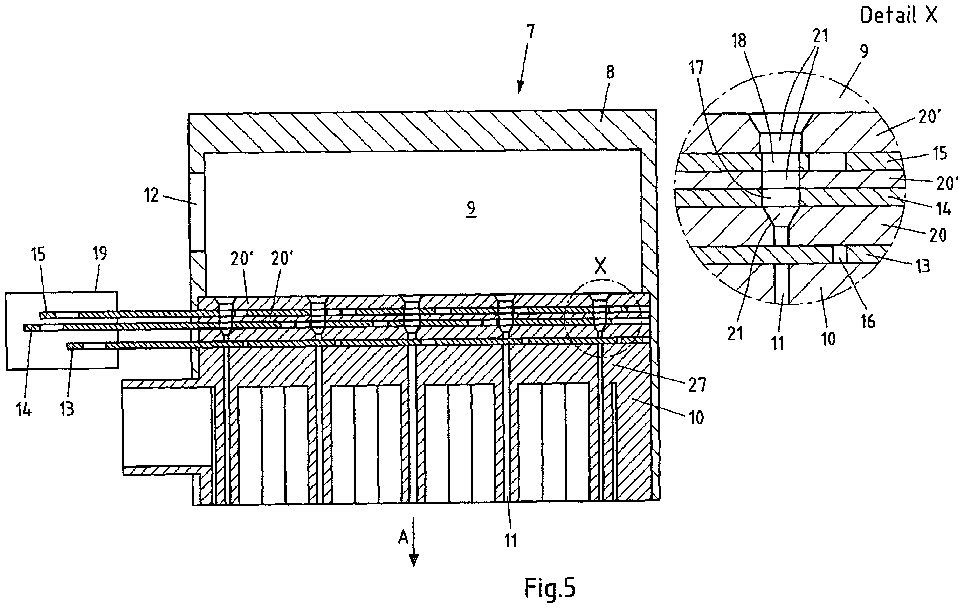

Der Blaskopf 7, über den der Druckluftstoß erzeugt und freigegeben wird, weist ein Blaskopfgehäuse 8 mit einer darin angeordneten Druckkammer 9 auf ( (Fig. 5).

Das Blaskopfgehäuse 8 weist an der zur Vorschubeinrichtung 3 weisenden Unterseite einen Gehäuseteil 10 mit einer Mehrzahl von Gehäuseöffnungen 11 auf, die das Innere der Druckkammer 9 mit der Umgebung (dem Bereich außerhalb des Blaskopfgehäuses 8) verbinden. Durch diese Gehäuseöffnungen 11 kann dann in besagter Abblasrichtung A ein von den Gehäuseöffnungen 11 zur Vorschubeinrichtung 3 gerichteter Druckluftstoß aus der Druckkammer 9 entweichen.

Um den Druckluftstoß optimal flächenmittig zum Etikett 5 ausrichten zu können, sind im Blaskopfgehäuse 8 und insbesondere in der Druckkammer 9 zwei Etikettengrößenanpassungsblenden 14 und 15 angeordnet, die abhängig von in einem Etikettendatenspeicher 24 abgelegten Daten (etikettenspezifischen Informationen) für verschiedene Etikettengrößen in unterschiedliche Positionen bewegt werden können, um dadurch während des Druckluftstoßes mehrere der Gehäuseöffnungen 11 zu blockieren und andere - wenn die Gehäuseöffnungen in dem Gehäuseteil nicht anderweitig, zum Beispiel durch den Verschlussschieber, blockiert sind - freizugeben.

Unabhängig vom Etikettendatenspeicher 24 weist die Vorrichtung 1 ferner einen Produktdatenspeicher 23 mit darin abgelegten produktspezifischen Informationen auf.

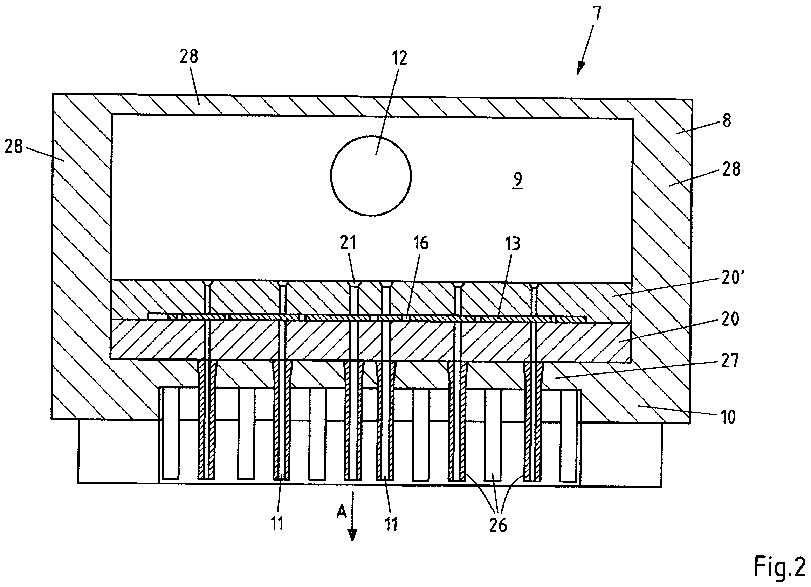

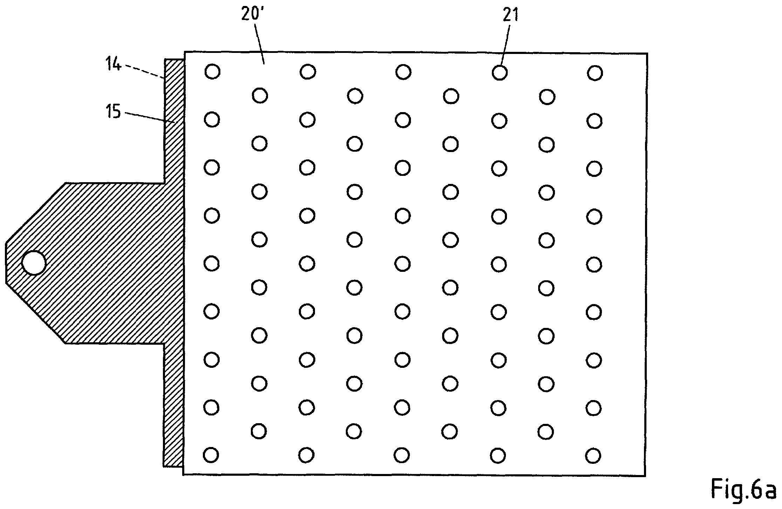

Die Anordnung und Funktionsweise der Etikettengrößenanpassungsblenden 14 und 15 wird im weiteren noch näher anhand der Figuren 5 und 6a) bis 6c) erläutert. Zunächst soll aber auf die Funktionsweise eines anderen Schieberelements in der Druckkammer 9 eingegangen werden. So ist ein Verschlussschieber 13 vorgesehen, der dazu dient, alle Gehäuseöffnungen 11 vollständig zu blockieren, wenn in der Druckkammer 9 ein Überdruck aufgebaut wird, und vollständig freizugeben, um den Überdruck schlagartig zur Erzeugung des besagten Druckluftstoßes durch die freien (das heißt nicht von der oder den Etikettengrößenanpassungsblenden blockierten) Gehäuseöffnungen 11 abzuleiten. Die Funktionsweise des Verschlussschiebers 13 wird im Folgenden anhand des nicht erfindungsgemäßen Ausführungsbeispiels in den Figuren 2 bis 4 verdeutlicht.

Die Figuren 2 bis 4 zeigen nur ein einziges in der Druckkammer 9 angeordnetes Schieberelement, nämlich den Verschlussschieber 13, sowie eine vertikal darunter angeordnete Lochplatte 20 und eine vertikal darüber angeordnete Lochplatte 20'. Wie in dem weiteren Ausführungsbeispiel in Fig. 5 dargestellt ist, können aber vertikal über dem Verschlussschieber 13, erfindungsgemäß mit einer vertikal dazwischen angeordneten Lochplatte 20', noch eine erste Etikettengrößenanpassungsblende 14 und optional, gegebenenfalls mit einer vertikal dazwischen angeordneten weiteren Lochplatte 20', eine zweite Etikettengrößenanpassungsblende 15 als zusätzliche Schieberelemente vorgesehen sein. Diese Etikettengrößenanpassungsblende 15 ist aber nicht zwingend und kann beispielsweise in dem Fall entfallen, wenn eine Ausrichtung des Blaskopfes gegenüber unterschiedlich großen Etiketten auf andere Weise erfolgt, beispielsweise in Transportrichtung X mittels der in Fig. 1 beispielhaft dargestellten Fördereinrichtung 25, die Etiketten 5 von der Etikettenspendeeinrichtung 4 zur Abblasposition P transportiert, oder in Querrichtung mittels des Vorsehens einer Verfahrbarkeit des gesamten Blaskopfes.

In Fig. 2 ist beispielhaft der Aufbau einer Druckkammer 9 für eine Vorrichtung 1 gemäß Fig. 1 dargestellt. Die Druckkammer 9 ist nach unten hin von einem Gehäuseteil 10 des Blaskopfgehäuses 8 begrenzt, in welchem die Gehäuseöffnungen 11 angeordnet sind. Die Gehäuseöffnungen 11 werden hier von einer Mehrzahl von Hohlzylindern 26 gebildet, die sich von einem plattenförmigen Abschnitt 27 des Gehäuseteils 10 in Abblasrichtung A erstrecken. Die Hohlzylindern 26 sind hier beispielhaft als separate Hülsen ausgebildet, die mechanisch mit dem Gehäuseteil 10 dichtend verbunden sind. Alle übrigen Seiten der Druckkammer 9 sind von Druckkammerwänden 28 blockiert. In einer der Druckkammerwände 28 ist ein Druckluftanschluss 12 zum Einleiten von Druckluft in die Druckkammer 9 vorgesehen. Der Druckluftanschluss 12 ist hier lediglich schematisch als Öffnung dargestellt. Durch diese Öffnung gelangt Luft mit Überdruck (Druck höher als der Umgebungsdruck bzw. atmosphärische Druck) in die Druckkammer 9.

Am unteren Ende der Druckkammer 9 befindet sich, hier auf einer optionalen stationären Lochplatte 20 gelagert, ein Schieberelement in Form eines Verschlussschiebers 13. Dieser Verschlussschieber 13 ist zwischen der Lochplatte 20, die auf dem Gehäuseteil 10 mit den Gehäuseöffnungen 11 aufliegt, und einer weiteren Lochplatte 20' dichtend angeordnet. "Dichtend" bedeutet im Sinne der Erfindung immer gasdicht.

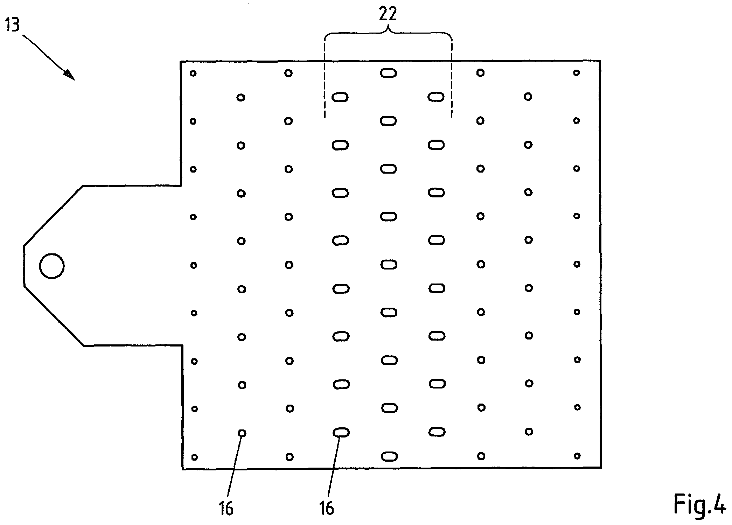

Der Verschlussschieber 13 ist, wie Fig. 4 zeigt, mit einer Mehrzahl von Löchern 16 versehen. In einer ersten Position des Verschlussschiebers 13 relativ zu dem gegenüber dem übrigen Blaskopfgehäuse 8 stationären (unbeweglichen) Gehäuseteil 10 und den ebenfalls stationären Lochplatten 20 und 20' blockiert der Verschlussschieber 13 alle Gehäuseöffnungen 11 (gemeint sind die in Abblasrichtung A verlaufenden Kanäle in dem Gehäuseteil 10 bzw. in den Hohlzylindern 26). Dieser Zustand des Blaskopfes 7 ist in Fig. 2 dargestellt und dient zum Befüllen der Druckkammer 9 mit Druckluft.

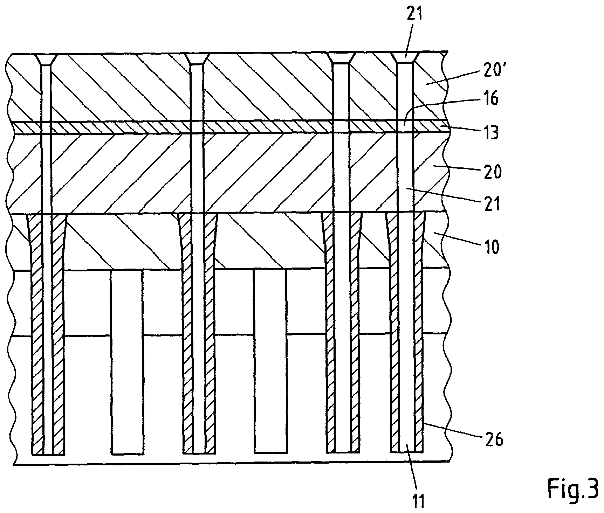

Der Verschlussschieber 13 kann dann zum Erzeugen eines Druckluftstoßes in die in Fig. 3 dargestellte zweite Position verschoben werden, in der die in der ersten Position noch vom Verschlussschieber 13 blockierten Gehäuseöffnungen 11 freigegeben sind. Die unter Druck stehende Luft in der Druckkammer 9 kann dann schlagartig durch die nicht von einer der Etikettengrößenanpassungsblenden blockierten Gehäuseöffnungen 11 bzw. Kanäle im Gehäuseteil 10 in Ablasrichtung A entweichen. Der so erzeugte Druckluftstoß befördert ein in der Abblasposition P befindliches Etikett 5 dann auf die Oberfläche eines darunter befindlichen Produkts 2.

Wie Fig. 3 zeigt, weist jede stationäre Lochplatte 20 bzw. 20' Lochplattenöffnungen 21 auf, die mit den Gehäuseöffnungen 11 exakt fluchten. Wenn sich der Verschlussschieber 13 in der zweiten Position befindet, in der die Gehäuseöffnungen 11 vom Verschlussschieber freigegeben sind, wird ein durchgehender Kanal zum Entweichen des Druckluftstoßes jeweils von einer Lochplattenöffnung 21 über das jeweils dazu fluchtende Loch 16 im Verschlussschieber 13 und schließlich über die jeweils dazu fluchtende Gehäuseöffnung 11 im Gehäuseteil 10 gebildet.

Fig. 4 zeigt ein Ausführungsbeispiel eines plattenförmig ausgebildeten Verschlussschiebers 13, wie er zuvor beschrieben wurde. Bei diesem Ausführungsbeispiel sind die Löcher 16, die in dem (bezogen auf die Bewegungsrichtung des Verschlussschiebers 13) mittleren Abschnitt 22 angeordnet sind, anders geformt als die übrigen Löcher 16 in den beiden dazu benachbarten Abschnitten. So sind die Löcher 16 im mittleren Abschnitt 22 hier als Langlöcher ausgebildet, wohingegen die übrigen Löcher 16 einen kreisrunden Querschnitt haben. Außerdem haben die Löcher 16 in dem mittleren Abschnitt 22 eine größere Breite als die Löcher 16 mit dem kreisrunden Querschnitt. Dadurch wird beim Verschieben des Verschlussschiebers 13 von der ersten Position in die zweite Position ein Druckluftstoß bewirkt, der früher und stärker auf die Etikettenmitte wirkt, wodurch das jeweilige Etikett 5 mittig leicht vorgefaltet wird, um dessen Flugeigenschaften zu verbessern.

Fig. 5 zeigt ein Ausführungsbeispiel mit der optionalen zusätzlichen Anordnung der beiden Etikettengrößenanpassungsblenden 14 und 15 über dem Verschlussschieber 13. Die beiden Etikettengrößenanpassungsblenden 14 und 15 sind ebenfalls plattenförmig ausgebildet und genau wie der Verschlussschieber 13 senkrecht zur Abblasrichtung A zwischen einer ersten Position und einer zweiten Position bewegbar. Die Bewegung wird hier beispielsweise durch einen Antrieb 19 bewirkt, kann aber auch von Hand durchgeführt werden.

Wenn die Gehäuseöffnungen 11 nicht anderweitig blockiert sind, das heißt wenn im vorliegenden Fall der Verschlussschieber 13 in der zweiten Position ist und daher die Gehäuseöffnungen 11 alle freigibt, wird mit einer Etikettengrößenanpassungsblende jeweils erreicht, dass in der ersten Position der jeweiligen Etikettengrößenanpassungsblende mehrere Gehäuseöffnungen 11 vollständig freigegeben sind und die übrigen Gehäuseöffnungen 11 vollständig blockiert sind, während in der zweiten Position dieser Etikettengrößenanpassungsblende alle Gehäuseöffnungen 11 vollständig freigegeben sind. Letzteres ist in Fig. 5 dargestellt, wo sich beide Etikettengrößenanpassungsblenden 14 und 15 in der zweiten Position befinden, in der alle Gehäuseöffnungen 11 freigegeben sind.

Diesbezüglich sei angemerkt, dass in den hier beschriebenen Ausführungsbeispielen die erste Position und zweite Position nur beispielhaft Endpositionen darstellen. Insbesondere die zweite Position kann aber auch eine Zwischenposition, insbesondere eine von mehreren Zwischenpositionen, zwischen der ersten und einer weiteren Endposition sein. So wäre auch der Fall denkbar, dass in der ersten Position der jeweiligen Etikettengrößenanpassungsblende mehrere Gehäuseöffnungen 11 vollständig freigegeben sind und die übrigen Gehäuseöffnungen 11 vollständig blockiert sind, in einer zweiten Position dieser Etikettengrößenanpassungsblende alle Gehäuseöffnungen 11 nur teilweise freigegeben sind oder nur einige der Gehäuseöffnungen 11 vollständig freigegeben sind. und in einer dritten Position dieser Etikettengrößenanpassungsblende alle Gehäuseöffnungen 11 vollständig freigegeben sind.

Wie insbesondere das Detail X in Fig. 5 verdeutlicht, wird bei geöffnetem Verschlussschieber 13 (Verschlussschieber 13 in der zweiten Position) ein Kanal für den Druckluftstoß gebildet durch die fluchtend zueinander angeordneten Löcher 17 und 18 der beiden Etikettengrößenanpassungsblenden 14 und 15, die jeweiligen Lochplattenöffnungen 21, das Loch 16 im Verschlussschieber 13 und schließlich die Gehäuseöffnung 11 des Gehäuseteils 10, wohingegen in der im Detail X gezeigten Stellung des Verschlussschiebers 13 dieser Kanal blockiert ist.

Wie die Figuren 6a) bis 6c) veranschaulichen, können bei Vorhandensein zweier Etikettengrößenanpassungsblenden 14 und 15 in der ersten Position unterschiedliche Bereiche von Gehäuseöffnungen 11 freigegeben werden. Die Ansichten in den Figuren 6a) bis 6c) sind vertikal von oben auf eine optionale weitere stationäre Lochplatte 20' gerichtet, die sich vertikal über den Etikettengrößenanpassungsblenden 14 und 15 befinden kann (in Fig. 5 nicht dargestellt), wobei die optionale stationäre Lochplatte 20' dieselben Merkmale wie die stationäre Lochplatte 20 aufweisen kann.

In Fig. 6a) ist erkennbar, dass alle Lochplattenöffnungen 21 der Lochplatte 20 freigegeben sind, wenn sich beide Verschlussschieber 14 und 15 in der zweiten Position befinden. Mit anderen Worten sind in diesem Fall auch sämtliche Gehäuseöffnungen 11 des Gehäuseteils 10 freigegeben, wenn sich der Verschlussschieber 13 ebenfalls in der zweiten (geöffneten) Position befindet.

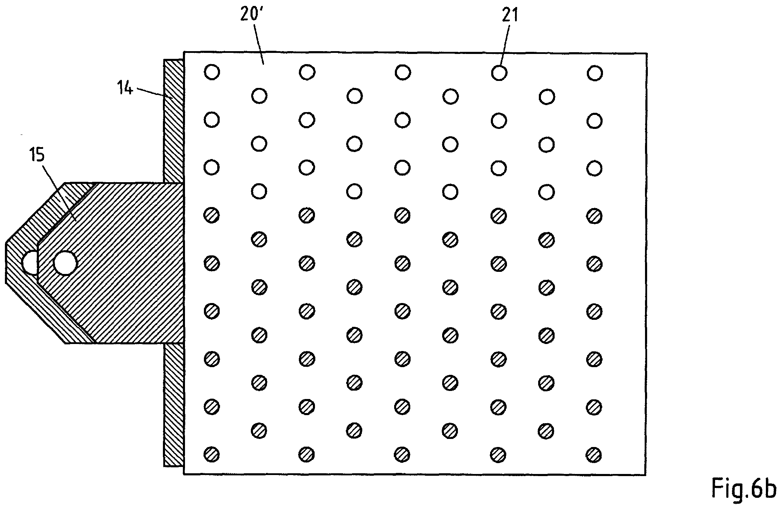

In Fig. 6b) befindet sich die erste Etikettengrößenanpassungsblende 14 in der ersten Position, wohingegen die zweite Etikettengrößenanpassungsblende 15 weiterhin in der zweiten Position wie in Fig. 6a ist. In diesem Fall ist nur ein Teil der Lochplattenöffnungen 21 der Lochplatte 20 freigegeben, wohingegen ein größerer Teil der Lochplattenöffnungen 21 blockiert ist. Entsprechend sind in diesem Fall bei geöffnetem Verschlussschieber 13 auch die mit den freigegebenen Lochplattenöffnungen 21 fluchtenden Gehäuseöffnungen 11 freigegeben, während die mit den blockierten Lochplattenöffnungen 21 fluchtenden Gehäuseöffnungen 11 blockiert sind.

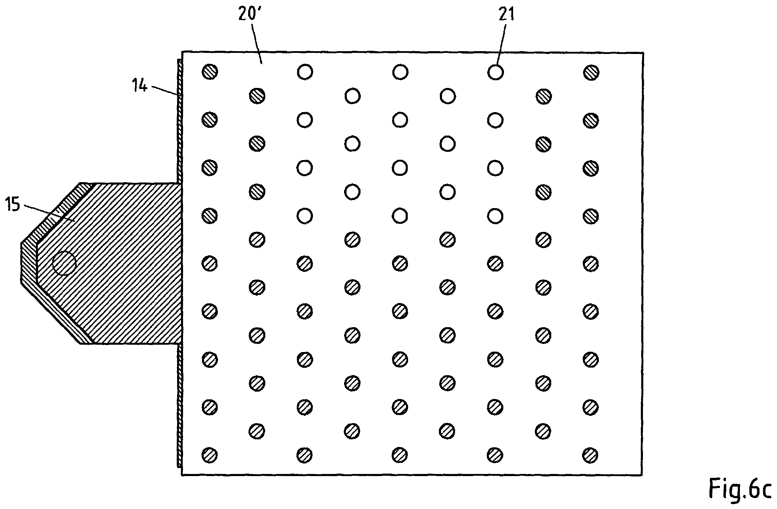

Fig. 6c) zeigt eine Anordnung der beiden Etikettengrößenanpassungsblenden 14 und 15, in welcher sich beide Etikettengrößenanpassungsblenden in der ersten Position befinden. In diesem Fall ist der Bereich mit den freigegebenen Lochplattenöffnungen 21 und entsprechend (bei geöffnetem Verschlussschieber 13) der Bereich mit den freigegebenen Gehäuseöffnungen 11 noch kleiner als in dem in Fig. 6b) dargestellten Zustand.

Wie die Figuren 6a) bis 6c) veranschaulichen, lassen sich durch Verstellen der beiden Etikettengrößenanpassungsblenden 14 und 15 individuelle Bereiche von Lochplattenöffnungen 21 und Gehäuseöffnungen 11 freigeben, durch die dann, wenn sich der Verschlussschieber 13 in der zweiten (geöffneten) Position befindet, der Druckluftstoß wirkt. Diese Möglichkeit des Bildens individueller Bereiche erlaubt die Anpassung bzw. Ausrichtung des Druckluftstoßes relativ zur Etikettenfläche, so dass auch Etiketten 5 mit verschiedenen Abmessungen immer optimal vom Druckluftstoß erfasst werden können.

## Patentansprüche

1. Vorrichtung (1) zum Etikettieren von einzelnen Produkten (2), insbesondere Packungen oder Waren,
- mit einer Vorschubeinrichtung (3) zum Transport eines jeweiligen Produkts (2) entlang eines Transportweges,
- mit einer Etikettenspendeeinrichtung (4) zum Bereitstellen eines Etiketts (5) und
- mit einer Etikettenaufbringeinrichtung (6) mit einem Blaskopf (7) zum Aufbringen des Etiketts (5) auf die Oberfläche des Produkts (2),
- wobei der Blaskopf (7) ein Blaskopfgehäuse (8) mit einer Druckkammer (9) aufweist,
- wobei das Blaskopfgehäuse (8) an der zur Vorschubeinrichtung (3) weisenden Seite einen Gehäuseteil (10) mit einer Mehrzahl von Gehäuseöffnungen (11) aufweist, die das Innere der Druckkammer (9) mit der Umgebung des Blaskopfgehäuses (8) verbinden und durch die ein in eine Abblasrichtung (A) von den Gehäuseöffnungen (11) zur Vorschubeinrichtung (3) gerichteter Druckluftstoß entweichen kann,
- wobei die Druckkammer (9) einen Druckluftanschluss (12) zum Einleiten von Druckluft in die Druckkammer (9) aufweist und
**dadurch gekennzeichnet,**
- **dass** die Etikettenaufbringeinrichtung (6) mindestens zwei Schieberelemente (13,14,15) aufweist, die jeweils zwischen einer ersten Position, in der das jeweilige Schieberelement (13,14,15) zumindest einige der Gehäuseöffnungen (11) vollständig blockieren kann, und einer zweiten Position, in der das jeweilige Schieberelement (13,14,15) mehrere dieser Gehäuseöffnungen (11) zumindest teilweise freigeben kann, verschiebbar sind,
- **dass** in den mindestens zwei Schieberelementen (13,14,15) Löcher (16,17,18) vorgesehen sind, die derart angeordnet sind,
- dass sie in der zweiten Position des jeweiligen Schieberelements (13,14,15) mit den in der ersten Position durch das jeweilige Schieberelement (13,14,15) blockierbaren Gehäuseöffnungen (11) zumindest teilweise in Überdeckung bringbar sind und
- dass sie in der ersten Position des jeweiligen Schieberelements (13,14,15) zu diesen Gehäuseöffnungen (11) versetzt sind, so dass keine Überdeckung gegeben ist, und
- **dass** die Vorrichtung derart gestaltet ist, dass der Druckluftstoß durch die Löcher (16,17,18) in den mindestens zwei Schieberelementen (13,14,15) und durch die damit zumindest teilweise in Überdeckung stehende Gehäuseöffnungen (11) aus der Druckkammer (9) entweichen kann.

2. Vorrichtung (1) nach Anspruch 1, **dadurch gekennzeichnet, dass** die Etikettenaufbringeinrichtung (6) mindestens drei Schieberelemente (13,14,15) aufweist, die zwischen einer ersten Position, in der das jeweilige Schieberelement (13,14,15) zumindest einige der Gehäuseöffnungen (11) vollständig blockieren kann, und einer zweiten Position, in der das jeweilige Schieberelement (13,14,15) mehrere dieser Gehäuseöffnungen (11), vorzugsweise alle diese Gehäuseöffnungen (11) zumindest teilweise freigeben kann, bewegbar sind, wobei in jedem Schieberelement (13,14,15) jeweils Löcher (16,17,18) vorgesehen sind, die derart angeordnet sind, dass sie in der zweiten Position des jeweiligen Schieberelements (13,14,15) mit den in der ersten Position durch das Schieberelement (13,14,15) blockierbaren Gehäuseöffnungen (11) zumindest teilweise in Überdeckung bringbar sind und in der ersten Position des jeweiligen Schieberelements (13,14,15) zu diesen Gehäuseöffnungen (11) versetzt sind, so dass keine Überdeckung gegeben ist.

3. Vorrichtung nach Anspruch 1 oder 2, **dadurch gekennzeichnet, dass** mindestens ein Schieberelement (13,14,15), vorzugsweise alle Schieberelemente (13,14,15), im Innern der Druckkammer (9) angeordnet ist/sind.

4. Vorrichtung nach einem der vorangehenden Ansprüche, **dadurch gekennzeichnet, dass** mindestens ein Schieberelement (13,14,15), vorzugsweise alle Schieberelemente (13,14,15),
- jeweils mit einem Antrieb (19) verbunden ist/sind, und/oder
- plattenförmig ausgebildet ist/sind, und/oder
- winklig, insbesondere senkrecht, zur Abblasrichtung (A) zwischen der jeweiligen ersten Position und zweiten Position bewegbar ist/sind.

5. Vorrichtung (1) nach einem der vorangehenden Ansprüche, **dadurch gekennzeichnet, dass** mindestens ein Schieberelement (13) einen Verschlussschieber (13) bildet, der in der ersten Position alle Gehäuseöffnungen (11) vollständig blockiert und in der zweiten Position einige, vorzugsweise alle, Gehäuseöffnungen (11) zumindest teilweise, vorzugsweise vollständig, freigibt, wobei optional der Verschlussschieber (13) dichtend an dem Gehäuseteil (10) mit den Gehäuseöffnungen (11), insbesondere an der der Vorschubeinrichtung (3) abgewandten Seite des Gehäuseteils (10), anliegt und vorzugsweise parallel zu dem Gehäuseteil (10), insbesondere senkrecht zu der Mittelachse der Gehäuseöffnungen (11), bewegbar ist.

6. Vorrichtung (1) nach Anspruch 5, **dadurch gekennzeichnet, dass** in der Druckkammer (9) mindestens eine stationäre Lochplatte (20, 20') mit Lochplattenöffnungen (21) angeordnet ist, insbesondere wobei die Anzahl an Lochplattenöffnungen (21) der Anzahl an Gehäuseöffnungen (11) entspricht und insbesondere die Lochplattenöffnungen (21) mit den Gehäuseöffnungen (11) fluchten, wobei insbesondere sich die Lochplattenöffnungen (21) zu den Gehäuseöffnungen (11) hin verengen, wobei optional der Verschlussschieber (13) zwischen der stationären Lochplatte (20,20') und dem Gehäuseteil (10) mit den Gehäuseöffnungen (11) angeordnet ist.

7. Vorrichtung (1) nach Anspruch 6, **dadurch gekennzeichnet, dass** der Verschlussschieber (13) dichtend an der stationären Lochplatte (20,20'), insbesondere an der der Vorschubeinrichtung (3) zugewandten Seite der stationären Lochplatte (20,20'), anliegt und vorzugsweise parallel zur stationären Lochplatte (20,20'), insbesondere senkrecht zu der Mittelachse der Lochplattenöffnungen (21), bewegbar ist.

8. Vorrichtung (1) nach einem der Ansprüche 5 bis 7, **dadurch gekennzeichnet, dass** die Löcher (16) des Verschlussschiebers (13) verschiedene Lochquerschnitte haben, wobei die in einem mittleren Abschnitt (22) angeordneten Löcher (16) insbesondere eine größere Länge und/oder eine größere Breite und/oder eine größere Querschnittsfläche als die übrigen Löcher (16) haben, wobei optional der Lochquerschnitt der übrigen Löcher (16) dem Querschnitt der Gehäuseöffnungen (11) entspricht.

9. Vorrichtung (1) nach einem der vorangehenden Ansprüche, **dadurch gekennzeichnet, dass** mindestens ein Schieberelement (14,15), insbesondere zwei Schieberelemente (14,15), jeweils eine Etikettengrößenanpassungsblende (14,15) bildet/bilden, die in der ersten Position mehrere Gehäuseöffnungen (11) zumindest teilweise, vorzugsweise vollständig, freigibt und die übrigen Gehäuseöffnungen (11) vollständig blockiert und in der zweiten Position alle Gehäuseöffnungen (11) zumindest teilweise, vorzugsweise vollständig, freigibt.

10. Vorrichtung (1) nach Anspruch 9, **dadurch gekennzeichnet, dass** eine Etikettengrößenanpassungsblende (14) in der ersten Position andere Gehäuseöffnungen (11) freigibt als eine andere Etikettengrößenanpassungsblende (15), wobei insbesondere, wenn beide Etikettengrößenanpassungsblenden (14,15) in der ersten Position sind, alle Gehäuseöffnungen (11) blockiert sind und/oder, wenn beide Etikettengrößenanpassungsblenden (14,15) in der zweiten Position sind, alle Gehäuseöffnungen (11) freigegeben sind,
wobei optional die eine Etikettengrößenanpassungsblende (14) und die andere Etikettengrößenanpassungsblende (15) gleichzeitig in ihrer ersten Position positionierbar sind, wodurch insbesondere eine geringere Anzahl an Gehäuseöffnungen (11) freigegeben ist als in dem Fall, dass nur die eine Etikettengrößenanpassungsblende (14) oder nur die andere Etikettengrößenanpassungsblende (15) in ihrer erste Position positioniert ist.

11. Vorrichtung (1) nach einem der Ansprüche 9 oder 10, **dadurch gekennzeichnet, dass** mindestens eine Etikettengrößenanpassungsblende (14) dichtend an der stationären Lochplatte (20,20'), insbesondere an der der Vorschubeinrichtung (3) abgewandten Seite der stationären Lochplatte (20,20'), anliegt und vorzugsweise parallel zu der stationären Lochplatte (20,20'), insbesondere senkrecht zu der Mittelachse der Lochplattenöffnungen (21), bewegbar ist, wobei optional jede der Etikettengrößenanpassungsblenden (14,15) und/oder die von der Vorschubeinrichtung (3) entfernteste der Etikettengrößenanpassungsblenden (14) dichtend an einer stationären Lochplatte (20,20') anliegt, wobei die dichtend an der stationären Lochplatte (20,20') anliegende Etikettengrößenanpassungsblende (14,15) insbesondere an der der Vorschubeinrichtung (3) zugekehrten Seite der stationären Lochplatte (20,20') anliegt.

12. Vorrichtung (1) nach einem der Ansprüche 9 bis 11, **dadurch gekennzeichnet, dass** eine Etikettengrößenanpassungsblende (15) dichtend an einer anderen Etikettengrößenanpassungsblende (14), insbesondere an der der Vorschubeinrichtung (3) abgewandten Seite der anderen Etikettengrößenanpassungsblende (14), anliegt und vorzugsweise parallel zu der anderen Etikettengrößenanpassungsblende (14), insbesondere senkrecht zu der Mittelachse der Löcher (17) der anderen Etikettengrößenanpassungsblende (14), bewegbar ist.

13. Vorrichtung (1) nach einem der vorangehenden Ansprüche, **dadurch gekennzeichnet, dass** die Vorrichtung (1) ferner einen Produktdatenspeicher (23) zum Bereitstellen von produktspezifischen Informationen und einen Etikettendatenspeicher (24) zum Bereitstellen von etikettenspezifischen Informationen aufweist, wobei in dem Etikettendatenspeicher (24) insbesondere die jeweilige Position der Etikettengrößenanpassungsblende(n) (14,15) während des Druckluftstoßes individuell für verschiedene Etikettengrößen abgelegt ist.

14. Verfahren zum Etikettieren von einzelnen Produkten (2), insbesondere Packungen oder Waren, vorzugsweise unter Verwendung einer Vorrichtung (1) nach einem der vorangehenden Ansprüche,
- bei dem ein Produkt (2) mit einer Vorschubeinrichtung (3) entlang eines Transportweges transportiert wird,
- bei dem das Produkt (2) auf dem Transportweg an einem Blaskopf (7) einer Etikettenaufbringeinrichtung (6) vorbeigeführt wird,
- bei dem in einer Etikettenspendeeinrichtung (4) Etiketten (5) bereitgestellt werden,
- bei dem eines der Etiketten (5) von der Etikettenspendeeinrichtung (4) in eine Abblasposition (P) zwischen dem Blaskopf (7) und der Vorschubeinrichtung (3) transportiert wird,
- bei dem in einer Druckkammer (9) des Blaskopfes (7) ein Überdruck aufgebaut wird und
- bei dem das Etikett (5) von der Abblasposition (P) mittels eines in eine Abblasrichtung (A) von der Abblasposition (P) zur Vorschubeinrichtung (3) gerichteten Druckluftstoßes auf das Produkt (2) übertragen wird, sobald sich das Produkt (2) in Abblasrichtung (A) vor der Abblasposition (P) befindet, **dadurch gekennzeichnet,**
- **dass** der Druckluftstoß durch Löcher (16,17,18) in mindestens zwei Schieberelementen (13,14,15) und durch damit zumindest teilweise in Überdeckung stehende Gehäuseöffnungen (11) in einem zur Vorschubeinrichtung (3) weisenden Gehäuseteil (10), die das Innere der Druckkammer (9) mit der Umgebung des Blaskopfes (7) verbinden, aus der Druckkammer (9) entweicht,
wobei die Schieberelemente (13, 14, 15) jeweils zwischen einer ersten Position, in der das jeweilige Schieberelement (13, 14, 15) zumindest einige der Gehäuseöffnungen (11) vollständig blockieren kann, und einer zweiten Position, in der das jeweilige Schieberelement (13, 14, 15) mehrere dieser Gehäuseöffnungen (11) zumindest teilweise freigeben kann, verschiebbar sind.

15. Verfahren nach Anspruch 14, **dadurch gekennzeichnet, dass** der Druckluftstoß dadurch erzeugt wird, dass ein einen Verschlussschieber bildendes Schieberelement (13) von einer ersten Position, in der der Verschlussschieber (13) alle Gehäuseöffnungen (11) vollständig blockiert, während der Überdruck aufgebaut wird, in eine zweite Position bewegt wird, in der alle Gehäuseöffnungen (11) zumindest teilweise, vorzugsweise vollständig, freigegeben sind.

16. Verfahren nach Anspruch 14 oder 15, **dadurch gekennzeichnet, dass** vor dem Bewegen des Verschlussschiebers (13) von der ersten Position in die zweite Position mindestens ein eine Etikettengrößenanpassungsblende bildendes Schieberelement (14,15), insbesondere zwei jeweils eine Etikettengrößenanpassungsblende bildende Schieberelemente (14,15), jeweils in eine Position bewegt wird/werden, in der die jeweilige Etikettengrößenanpassungsblende (14,15) mehrere Gehäuseöffnungen (11) zumindest teilweise, vorzugsweise vollständig, freigibt und die übrigen Gehäuseöffnungen (11) vollständig blockiert.

## Claims

1. Apparatus (1) for labelling individual products (2), in particular packages or goods,
- having a feed device (3) for transporting a respective product (2) along a transport path, having a label dispensing device (4) for providing a label (5), and
- having a label application device (6) with a blower head (7) for applying the label (5) to the surface of the product (2),
- wherein the blower head (7) has a blower head housing (8) with a pressure chamber (9),
- wherein the blower head housing (8) has, on the side pointing toward the feed device (3), a housing part (10) with a multiplicity of housing openings (11) which connect the interior of the pressure chamber (9) to the surroundings of the blower head housing (8) and through which a compressed-air shock directed in a blowing-off direction (A) from the housing openings (11) to the feed device (3) can escape,
- wherein the pressure chamber (9) has a compressed-air port (12) for the introduction of compressed air into the pressure chamber (9), and
**characterized**
- **in that** the label application device (6) has at least two slide elements (13, 14, 15) which are each displaceable between a first position, in which the respective slide element (13, 14, 15) can completely block at least some of the housing openings (11), and a second position, in which the respective slide element (13, 14, 15) can at least partially open up several of said housing openings (11),
- **in that**, in the least two slide elements (13, 14, 15), there are provided holes (16, 17, 18) which are arranged
such that they can, in the second position of the respective slide element (13, 14, 15), be placed at least partially in overlap with the housing openings (11) that can be blocked in the first position by the respective slide element (13, 14, 15), and
such that they are, in the first position of the respective slide element (13, 14, 15), offset with respect to said housing openings (11), such that no overlap is realised, and
- **in that** the device is designed such that the compressed-air shock can escape from the pressure chamber (9) through the holes (16, 17, 18) in the at least two slide elements (13, 14, 15) and through the housing openings (11) at least partially overlapping said holes.

2. Apparatus (1) according to Claim 1, **characterized in that** the label application device (6) has at least three slide elements (13, 14, 15) which are movable between a first position, in which the respective slide element (13, 14, 15) can completely block at least some of the housing openings (11), and a second position, in which the respective slide element (13, 14, 15) can at least partially open up several of said housing openings (11), preferably all of said housing openings (11), wherein, in each slide element (13, 14, 15), there are provided in each case holes (16, 17, is) which are arranged such that they can, in the second position of the respective slide element (13, 14, 15), be placed at least partially in overlap with the housing openings (11) that can be blocked in the first position by the slide element (13, 14, 15), and are, in the first position of the respective slide element (13, 14, 15), offset with respect to said housing openings (11), such that no overlap is realized.

3. Apparatus according to Claim 1 or 2, **characterized in that** at least one slide element (13, 14, 15), preferably all of the slide elements (13, 14, 15) is/are arranged in the interior of the pressure chamber (9).

4. Apparatus according to one of the preceding claims, **characterized in that** at least one slide element (13, 14, 15), preferably all of the slide elements (13, 14, 15),
- is/are each connected to a drive (19), and/or
- is/are of plate-like form, and/or
- is/are movable at an angle, in particular perpendicularly, with respect to the blowing-off direction (A) between the respective first position and second position.

5. Apparatus (1) according to one of the preceding claims, **characterized in that** at least one slide element (13) forms a closure slide (13) which, in the first position, completely blocks all housing openings (11) and, in the second position, at least partially, preferably completely, opens up some, preferably all, of the housing openings (11), wherein optionally, the closure slide (13) bears sealingly against the housing part (10) with the housing openings (11), in particular against that side of the housing part (10) which is averted from the feed device (3), and is movable preferably parallel to the housing part (10), in particular perpendicular to the central axis of the housing openings (11) .

6. Apparatus (1) according to Claim 5, **characterized in that**, in the pressure chamber (9), there is arranged at least one static perforated plate (20, 20') with perforated plate openings (21), wherein in particular, the number of perforated plate openings (21) corresponds to the number of housing openings (11) and, in particular, the perforated plate openings (21) are aligned with the housing openings (11), wherein in particular, the perforated plate openings (21) narrow toward the housing openings (11), wherein optionally, the closure slide (13) is arranged between the static perforated plate (20, 20') and the housing part (10) with the housing openings (11).

7. Apparatus (1) according to Claim 6, **characterized in that** the closure slide (13) bears sealingly against the static perforated plate (20, 20'), in particular against that side of the static perforated plate (20, 20') which faces toward the feed device (3), and is movable preferably parallel to the static perforated plate (20, 20'), in particular perpendicular to the central axis of the perforated plate openings (21).

8. Apparatus (1) according to one of Claims 5 to 7, **characterized in that** the holes (16) of the closure slide (13) have different hole cross sections, wherein the holes (16) arranged in a central section (22) have in particular a larger length and/or a larger width and/or a larger cross-sectional area than the other holes (16), wherein optionally, the hole cross section of the other holes (16) corresponds to the cross section of the housing openings (11).

9. Apparatus (1) according to one of the preceding claims, **characterized in that** at least one slide element (14, 15), in particular two slide elements (14, 15), form(s) in each case one label size adaptation screen (14, 15) which, in the first position, at least partially, preferably completely, opens up several housing openings (11) and completely blocks the other housing openings (11) and, in the second position, at least partially, preferably completely, opens up all of the housing openings (11).

10. Apparatus (1) according to Claim 9, **characterized in that** a label size adaptation screen (14), in the first position, opens up different housing openings (11) than another label size adaptation screen (15), wherein in particular, if both label size adaptation screens (14, 15) are in the first position, all of the housing openings (11) are blocked, and/or, if both label size adaptation screens (14, 15) are in the second position, all of the housing openings (11) are opened up,
wherein optionally, one label size adaptation screen (14) and the other label size adaptation screen (15) are simultaneously positionable in their first position, whereby, in particular, a smaller number of housing openings (11) is opened up than in the case in which only one label size adaptation screen (14) or only the other label size adaptation screen (15) is positioned in its first position.

11. Apparatus (1) according to either of Claims 9 and 10, **characterized in that** at least one label size adaptation screen (14) bears sealingly against the static perforated plate (20, 20'), in particular against that side of the static perforated plate (20, 20') which is averted from the feed device (3), and is movable preferably parallel to the static perforated plate (20, 20'), in particular perpendicular to the central axis of the perforated plate openings (21), wherein optionally, each of the label size adaptation screens (14, 15) and/or that one of the label size adaptation screens (14) which is furthest remote from the feed device (3) bears sealingly against a static perforated plate (20, 20'), wherein the label size adaptation screen (14, 15) that bears sealingly against the static perforated plate (20, 20') bears in particular against that side of the static perforated plate (20, 20') which faces toward the feed device (3).

12. Apparatus (1) according to one of Claims 9 to 11, **characterized in that** one label size adaptation screen (15) bears sealingly against another label size adaptation screen (14), in particular against that side of the other label size adaptation screen (14) which is averted from the feed device (3), and is movable preferably parallel to the other label size adaptation screen (14), in particular perpendicular to the central axis of the holes (17) of the other label size adaptation screen (14).

13. Apparatus (1) according to one of the preceding claims, **characterized in that** the apparatus (1) furthermore has a product data memory (23) for providing product-specific information items and has a label data memory (24) for providing label-specific information items, wherein, in particular, the respective position of the label size adaptation screen(s) (14, 15) during the compressed-air shock is stored, individually for different label sizes, in the label data memory (24).

14. Method for labelling individual products (2), in particular packages or goods, preferably using an apparatus (1) according to one of the preceding claims,
- in which method a product (2) is transported by means of a feed device (3) along a transport path,
- in which method the product (2) is, on the transport path, carried past a blower head (7) of a label application device (6),
- in which method labels (5) are provided in a label dispensing device (4),
- in which method one of the labels (5) is transported from the label dispensing device (4) into a blowing-off position (P) between the blower head (7) and the feed device (3),
- in which method a positive pressure is built up in a pressure chamber (9) of the blower head (7), and
- in which method the label (5) is transferred from the blowing-off position (P) onto the product (2), by means of a compressed-air shock directed in a blowing-off direction (A) from the blowing-off position (P) to the feed device (3), as soon as the product (2) is situated in front of the blowing-off position (P) in the blowing-off direction (A),
**characterized**
- **in that** the compressed-air shock escapes from the pressure chamber (9) through holes (16, 17, 18) in at least two slide elements (13, 14, 15) and through housing openings (11), which at least partially overlap said holes, in a housing part (10) pointing towards the feed device (3), which housing openings connect the interior of the pressure chamber (9) to the surroundings of the blower head (7), wherein the slide elements (13, 14, 15) are each movable between a first position, in which the respective slide element (13, 14, 15) can completely block at least some of the housing openings (11), and a second position, in which the respective slide element (13, 14, 15) can at least partially open up several of said housing openings (11).

15. Method according to Claim 14, **characterized in that** the compressed-air shock is generated by virtue of a slide element (13), which forms a closure slide, being moved from a first position, in which the closure slide (13) completely blocks all of the housing openings (11) while the positive pressure is built up, into a second position, in which all of the housing openings (11) are at least partially, preferably completely, opened up.

16. Method according to Claim 14 or 15, **characterized in that**, before the movement of the closure slide (13) from the first position into the second position, at least one slide element (14, 15) which forms a label size adaptation screen, in particular two slide elements (14, 15) which form in each case one label size adaptation screen, is/are moved in each case into a position in which the respective label size adaptation screen (14, 15) at least partially, preferably completely, opens up several housing openings (11) and completely blocks the other housing openings (11).

## Revendications

1. Dispositif (1) pour l'étiquetage de produits individuels (2), en particulier d'emballages ou de marchandises, comprenant
- un dispositif d'avance (3) pour le transport d'un produit respectif (2) le long d'une voie de transport,
- un dispositif de distribution d'étiquettes (4) pour fournir une étiquette (5) et
- un dispositif d'application d'étiquettes (6) avec une tête de soufflage (7) pour appliquer l'étiquette (5) sur la surface du produit (2),
- la tête de soufflage (7) présentant un boîtier de tête de soufflage (8) avec une chambre de pression (9),
- le boîtier de tête de soufflage (8) présentant, au niveau du côté tourné vers le dispositif d'avance (3), une partie de boîtier (10) avec une pluralité d'ouvertures de boîtier (11) qui relient l'intérieur de la chambre de pression (9) à l'environnement du boîtier de tête de soufflage (8) et à travers lesquelles peut s'échapper un jet d'air sous pression orienté dans une direction de soufflage (A) depuis les ouvertures de boîtier (11) vers le dispositif d'avance (3),
- la chambre de pression (9) présentant un raccord d'air sous pression (12) pour l'introduction d'air sous pression dans la chambre de pression (9), et
**caractérisé en ce que**
- le dispositif d'application d'étiquettes (6) présente au moins deux éléments de coulisseau (13, 14, 15) qui peuvent chacun être déplacés entre une première position dans laquelle l'élément de coulisseau respectif (13, 14, 15) peut complètement bloquer au moins certaine des ouvertures de boîtier (11), et une deuxième position dans laquelle l'élément de coulisseau respectif (13, 14, 15) peut libérer au moins en parties plusieurs de ces ouvertures de boîtier (11),
- des trous (16, 17, 18) sont prévus dans les au moins deux éléments de coulisseau (13, 14, 15), lesquels sont disposés de telle sorte
- qu'ils puissent être amenés, dans la deuxième position de l'élément de coulisseau respectif (13, 14 15), de manière au moins en partie superposée avec les ouvertures de boîtier (11) pouvant être bloquées dans la première position par l'élément de coulisseau respectif (13, 14, 15) et
- qu'ils soient décalés par rapport à ces ouvertures de boîtier (11) dans la première position de l'élément de coulisseau respectif (13, 14, 15), de telle sorte qu'il ne se produise pas de superposition, et
- que le dispositif est configuré de telle sorte que le jet d'air sous pression puisse s'échapper hors de la chambre de pression (9) à travers les trous (16 17, 18) dans au moins deux éléments de coulisseau (13, 14, 15) et à travers les ouvertures de boîtier (11) les recouvrant au moins en partie.

2. Dispositif (1) selon la revendication 1, **caractérisé en ce que** le dispositif d'application d'étiquettes (6) présente au moins trois éléments de coulisseau (13, 14, 15) qui peuvent être déplacés entre une première position dans laquelle l'élément de coulisseau respectif (13, 14, 15) peut bloquer complètement au moins certaine des ouvertures de boîtier (11) et une deuxième position, dans laquelle l'élément de coulisseau respectif (13, 14, 15) peut au moins en partie libérer plusieurs de ces ouvertures de boîtier (11), de préférence la totalité de ces ouvertures de boîtier (11), des trous (16, 17, 18) étant à chaque fois prévus dans chaque élément de coulisseau (13, 14, 15), lesquels sont disposés de telle sorte que dans la deuxième position de l'élément de coulisseau respectif (13, 14, 15), ils puissent être amenés de manière à recouvrir au moins en partie les ouvertures de boîtier (11) pouvant être bloquées en partie par l'élément de coulisseau (13, 14, 15) dans la première position et qu'ils soient décalés par rapport à l'ouverture de boîtier (11) dans la première position de l'élément de coulisseau respectif (13, 14, 15), de telle sorte qu'il ne se produise aucune superposition.

3. Dispositif selon la revendication 1 ou 2, **caractérisé en ce qu'**au moins un élément de coulisseau (13, 14, 15), de préférence tous les éléments de coulisseau (13, 14, 15) sont disposés à l'intérieur de la chambre de pression (9).

4. Dispositif selon l'une quelconque des revendications précédentes, **caractérisé en ce qu'**au moins un élément de coulisseau (13, 14 15), de préférence tous les éléments de coulisseau (13, 14, 15),
- sont chacun connectés à un entraînement (19), et/ou
- sont réalisés sous forme de plaque, et/ou
- peuvent être déplacés suivant un certain angle, en particulier perpendiculairement, à la direction de soufflage (A) entre la première position respective et la deuxième position respective.

5. Dispositif (1) selon l'une quelconque des revendications précédentes, **caractérisé en ce qu'**au moins un élément de coulisseau (13) forme un coulisseau de fermeture (13) qui, dans la première position, bloque complètement toutes les ouvertures de boîtier (11) et qui, dans la deuxième position, libère au moins en partie, de préférence complètement, certaines, de préférence la totalité, des ouvertures de boîtier (11), le coulisseau de fermeture (13) s'appliquant optionnellement de manière hermétique contre la partie de boîtier (10) avec les ouvertures de boîtier (11), en particulier contre le côté de la partie de boîtier (10) opposée au dispositif d'avance (3), et de préférence pouvant être déplacé parallèlement à la partie de boîtier (10), en particulier perpendiculairement à l'axe médian des ouvertures de boîtier (11).

6. Dispositif (1) selon la revendication 5, **caractérisé en ce que** dans la chambre de pression (9) est disposée au moins une plaque perforée stationnaire (20, 20') avec les ouvertures de plaque perforée (21), en particulier dans laquelle le nombre d'ouvertures de plaque perforée (21) correspond au nombre des ouvertures de boîtier (11) et notamment les ouvertures de plaque perforée (21) sont en alignement avec les ouvertures de boîtier (11), les ouvertures de plaque perforée (21) se rétrécissant notamment vers les ouvertures de boîtier (11), le coulisseau de fermeture (13) étant optionnellement disposé entre la plaque perforée stationnaire (20, 20') et la partie de boîtier (10) avec les ouvertures de boîtier (11).

7. Dispositif (1) selon la revendication 6, **caractérisé en ce que** le coulisseau de fermeture (13) s'applique hermétiquement contre la plaque perforée stationnaire (20, 20') en particulier contre le côté de la plaque perforée stationnaire (20, 20') tourné vers le dispositif d'avance (3) et de préférence peut être déplacé parallèlement à la plaque perforée stationnaire (20, 20') en particulier perpendiculairement à l'axe médian des ouvertures de plaque perforée (21).

8. Dispositif (1) selon l'une quelconque des revendications 5 à 7, **caractérisé en ce que** les trous (16) de coulisseau de fermeture (13) présentent des sections transversales de trou différentes, les trous (16) disposés dans une portion centrale (22) présentant notamment une plus grande longueur et/ou une plus grande largeur et/ou une plus grande surface en section transversale que le reste des trous (16), la section transversale de trou du reste des trous (16) correspondant optionnellement à la section transversale des ouvertures de boîtier (11).

9. Dispositif (1) selon l'une quelconque des revendications précédentes, **caractérisé en ce qu'**au moins un élément de coulisseau (14, 15), en particulier deux éléments de coulisseau (14, 15) forment à chaque fois un diaphragme d'adaptation à la taille des étiquettes (14, 15), qui, dans la première position, libère au moins en partie, de préférence complètement, plusieurs ouvertures de boîtier (11) et qui bloque complètement les autres ouvertures de boîtier (11) et qui, dans la deuxième position, libère au moins en partie, de préférence complètement, toutes les ouvertures de boîtier (11).

10. Dispositif (1) selon la revendication 9, **caractérisé en ce qu'**un diaphragme d'adaptation à la taille des étiquettes (14), dans la première position, libère d'autres ouvertures de boîtier (11) qu'un autre diaphragme d'adaptation à la taille des étiquettes (15), toutes les ouvertures de boîtier (11) étant bloquées notamment lorsque les deux diaphragmes d'adaptation à la taille des étiquettes (14, 15) sont dans la première position et/ou toutes les ouvertures de boîtier (11) étant libérées lorsque les deux diaphragmes d'adaptation à la taille des étiquettes (14, 15) sont dans la deuxième position,
l'un des diaphragmes d'adaptation à la taille des étiquettes (14) et l'autre diaphragme d'adaptation à la taille des étiquettes (15) pouvant optionnellement être positionnés dans leur première position, de sorte que notamment un nombre moins important d'ouvertures de boîtier (11) soient libérées par rapport au cas où seulement l'un (14) des diaphragmes d'adaptation à la taille des étiquettes ou seulement l'autre (15) des diaphragmes d'adaptation à la taille des étiquettes est positionné dans sa première position.

11. Dispositif (1) selon l'une quelconque des revendications 9 ou 10, **caractérisé en ce qu'**au moins un diaphragme d'adaptation à la taille des étiquettes (14) s'applique hermétiquement contre la plaque perforée stationnaire (20, 20') en particulier contre le côté de la plaque perforée stationnaire (20, 20') opposé au dispositif d'avance (3) et de préférence peut être déplacé parallèlement à la plaque perforée stationnaire (20, 20'), en particulier perpendiculairement à l'axe médian des ouvertures de la plaque perforée (21), optionnellement chacun des diaphragmes d'adaptation à la taille des étiquettes (14, 15) et/ou le diaphragme (14) le plus éloigné du dispositif d'avance (3) parmi les diaphragmes d'adaptation à la taille des étiquettes s'applique hermétiquement contre une plaque perforée stationnaire (20, 20'), le diaphragme d'adaptation à la taille des étiquettes (14, 15) s'appliquant hermétiquement contre la plaque perforée stationnaire (20, 20') s'appliquant notamment contre le côté de la plaque perforée stationnaire (20, 20') tourné vers le dispositif d'avance (3).

12. Dispositif (1) selon l'une quelconque des revendications 9 à 11, **caractérisé en ce qu'**un diaphragme d'adaptation à la taille des étiquettes (15) s'applique hermétiquement contre un autre diaphragme d'adaptation à la taille des étiquettes (14), en particulier contre le côté de l'autre diaphragme d'adaptation à la taille des étiquettes (14) opposé au dispositif d'avance (3) et peut être déplacé de préférence parallèlement à l'autre diaphragme d'adaptation à la taille des étiquettes (14), en particulier perpendiculairement à l'axe médian des trous (17) de l'autre diaphragme d'adaptation à la taille des étiquettes (14).

13. Dispositif (1) selon l'une quelconque des revendications précédentes, **caractérisé en ce que** le dispositif (1) présente en outre une mémoire de données de produits (23) pour fournir des informations spécifiques aux produits et une mémoire de données d'étiquettes (24) pour fournir des informations spécifiques aux étiquettes, la position respective du ou des diaphragmes d'adaptation à la taille des étiquettes (14, 15) pendant le jet d'air sous pression étant notamment consignée dans la mémoire de données d'étiquettes (24), de manière individuelle pour chaque taille d'étiquettes différentes.

14. Procédé d'étiquetage de produits individuels (2), en particulier d'emballages ou de marchandises, de préférence en utilisant un dispositif (1) selon l'une quelconque des revendications précédentes,
- dans lequel un produit (2) est transporté avec un dispositif d'avance (3) le long d'une voie de transport,
- dans lequel le produit (2) est guidé sur la voie de transport devant une tête de soufflage (7) d'un dispositif d'application d'étiquettes (6),
- dans lequel des étiquettes (5) sont fournies dans un dispositif de distribution d'étiquettes (4),
- dans lequel l'une des étiquettes (5) est transportée depuis le dispositif de distribution d'étiquettes (4) dans une position de soufflage (P) entre la tête de soufflage (7) et le dispositif d'avance (3),
- dans lequel, dans une chambre de pression (9) de la tête de soufflage (7), est établie une surpression et
- dans lequel l'étiquette (5) est transférée de la position de soufflage (P) au moyen d'un jet d'air sous pression orienté dans une direction de soufflage (A) depuis la position de soufflage (P) vers le dispositif d'avance (3) sur le produit (2), dès que le produit (2) se trouve dans la direction de soufflage (A) avant la position de soufflage (P),
**caractérisé en ce que**
- le jet d'air sous pression s'échappe hors de la chambre de pression (9) à travers des trous (16, 17, 18) dans au moins deux éléments de coulisseau (13, 14, 15) et à travers des ouvertures de boîtier (11) au moins en partie superposées à ceux-ci dans une partie de boîtier (10) tournée vers le dispositif d'avance (3), qui relient l'intérieur de la chambre de pression (9) à l'environnement de la tête de soufflage (7),
les éléments de coulisseau (13, 14, 15), pouvant être déplacés à chaque fois entre une première position dans laquelle l'élément de coulisseau respectif (13, 14, 15) peut bloquer complètement au moins certaines des ouvertures de boîtier (11) et une deuxième position, dans laquelle l'élément de coulisseau respectif (13, 14, 15) peut libérer au moins en partie plusieurs de ces ouvertures de boîtier (11).

15. Procédé selon la revendication 14, **caractérisé en ce que** le jet d'air sous pression est produit par le fait qu'un élément de coulisseau (13) formant un coulisseau de fermeture est déplacé d'une première position dans laquelle le coulisseau de fermeture (13) bloque complètement toutes les ouvertures de boîtier (11) tandis que la surpression est établie, dans une deuxième position dans laquelle toutes les ouvertures de boîtier (11) sont au moins en partie, de préférence complètement libérées.

16. Procédé selon la revendication 14 ou 15, **caractérisé en ce qu'**avant le déplacement du coulisseau de fermeture (13) de la première position dans la deuxième position, au moins un élément de coulisseau (14, 15) formant un diaphragme d'adaptation à la taille des étiquettes, en particulier deux éléments de coulisseau (14, 15) formant à chaque fois un diaphragme d'adaptation à la taille des étiquettes, sont à chaque fois déplacés dans une position dans laquelle le diaphragme respectif d'adaptation à la taille des étiquettes (14, 15) libère au moins en partie, de préférence complètement, plusieurs ouvertures de boîtier (11) et bloque complètement le reste des ouvertures de boîtier (11).
